# EUROPEAN PATENT APPLICATION

(11) **EP 4 420 810 A1**
(43) Date of publication of application: **28.08.2024**
(21) Application number: 21961392.4
(22) Date of filing: 20.10.2021
(51) Int. Cl.: B22F 9/00, H01B 1/22, B22F 1/00

(54) **COPPER MICROPARTICLE DISPERSION**

(71) Applicant: Kao Corporation, Tokyo 103-8210 (JP)
(72) Inventor: EYAMA, Takaaki, Wakayama-shi, Wakayama 640-8580 (JP); TAKIGUCHI, Osamu, Wakayama-shi, Wakayama 640-8580 (JP); YOSHIDA, Tomohide, Wakayama-shi, Wakayama 640-8580 (JP)
(74) Representative: Hoffmann Eitle
(86) International application number: PCT/JP2021/038814
(87) International publication number: WO 2023/067740

(57) **Abstract**

The present invention relates to a copper fine particle dispersion containing copper nanoparticles A, a carboxylic acid B having not less than 6 and not more than 14 carbon atoms, a compound C represented by the formula (1): RO-(CH₂CH₂O)ₙ-CH₂-COOH wherein R is a hydrocarbon group having not less than 6 and not more than 14 carbon atoms, and n represents an average molar number of addition of ethyleneoxy groups, and is a number of not less than 0.5 and not more than 20, and a dispersion medium D, in which the dispersion medium D contains at least one compound selected from the group consisting of a (poly)alkylene glycol, a (poly)alkylene glycol derivative, a terpene alcohol, glycerin and a glycerin derivative, a content of the carboxylic acid B in the dispersion is not less than 0.1% by mass, a content of the compound C in the dispersion is not less than 0.05% by mass, and a total content of the carboxylic acid B and the compound C in the dispersion is not more than 8% by mass, and also relates to a method for producing a bonded body, which includes the steps of allowing the aforementioned copper fine particle dispersion to intervene between a plurality of metal members, and heating the dispersion between the plurality of metal members.

## Description

### FIELD OF THE INVENTION

The present invention relates to a copper fine particle dispersion, and a method for producing a bonded body using the copper fine particle dispersion.

### BACKGROUND OF THE INVENTION

Copper is excellent in electrical conductivity and thermal conductivity, and has been therefore extensively used, for example, as a conductive wiring material, a thermal conductive material, a heat-exchanging material, a heat-dissipation material, etc.

The copper has also sometimes been used as an alternate material of solder for bonding objects to be bonded to each other owing to its excellent thermal conductivity.

In recent years, semiconductor devices called power devices have been intensively employed as power conversion/control devices, such as inverters, etc. The power devices serve for controlling a high electric current and therefore exhibit high heat generation upon their operation, unlike integrated circuits, such as memory units and microprocessors. For this reason, it has been required that solder used for mounting elements in the power devices has not only good bonding strength, but also good heat resistance. However, lead-free solder that has been extensively used in these days has such a defect that it tends to be deteriorated in heat resistance. In consequence, there have been made various proposals concerning techniques for bonding objects to be bonded to each other by using a copper fine particle dispersion in place of the solder, in which the copper fine particle dispersion is applied to the objects using various coating means, followed by firing the dispersion applied. The copper shows a stable oxidized condition at room temperature (25 °C), and therefore contains copper atoms kept in an oxidized state. For this reason, in order to bond the objects to be bonded to each other by using the copper fine particle dispersion, it is required that the copper atoms kept in an oxidized state are reduced and then fired to form a continuous phase of copper.

JP 2020-053404A (Patent Literature 1) aims at providing a copper paste that has high bonding strength to the objects to be bonded to each other, and discloses a copper paste containing a copper powder and a liquid medium, in which the liquid medium contains polyethylene glycol; copper particles constituting the copper powder have an average primary particle size of not less than 0.03 µm and not more than 1.0 µm; the surface of the respective copper particles is treated with a fatty acid having not less than 6 and not more than 18 carbon atoms; the crystallite size of the copper particles in a (111) plane thereof is not more than 50 nm; and the mass ratio of the copper powder in the copper paste is not less than 50% and not more than 99%.

In addition, JP 2017-172003A (Patent Literature 2) aims at providing a method for producing copper nanoparticles by which it is possible to produce monodisperse copper nanoparticles in a simplified manner, and discloses a method for producing copper nanoparticles, which is characterized by including a preparation step of dissolving a first metal salt containing copper, a complexing agent, a dispersant and a second metal salt containing a metal whose ionization tendency is lower than that of copper, in water to prepare a reaction solution, and a deposition step of adding a reducing agent to the reaction solution while stirring the reaction solution to deposit the copper nanoparticles.

### SUMMARY OF THE INVENTION

The present invention relates to a copper fine particle dispersion containing copper nanoparticles A, a carboxylic acid B having not less than 6 and not more than 14 carbon atoms, a compound C represented by the formula (1):

RO-(CH₂CH₂O)ₙ-CH₂-COOH (1)

wherein R is a hydrocarbon group having not less than 6 and not more than 14 carbon atoms; and n represents an average molar number of addition of ethyleneoxy groups, and is a number of not less than 0.5 and not more than 20,
and a dispersion medium D, in which:
   the dispersion medium D contains at least one compound selected from the group consisting of a (poly)alkylene glycol, a (poly)alkylene glycol derivative, a terpene alcohol, glycerin and a glycerin derivative;
   a content of the carboxylic acid B in the dispersion is not less than 0.1% by mass;
   a content of the compound C in the dispersion is not less than 0.05% by mass; and
   a total content of the carboxylic acid B and the compound C in the dispersion is not more than 8% by mass.

### DETAILED DESCRIPTION OF THE INVENTION

The copper fine particle dispersions that have been hitherto proposed as an alternate bonding material of solder are capable of exhibiting high heat resistance as compared to the solder, but still leave much room for improvement in bonding strength to objects to be bonded to each other. In addition, the conventional copper fine particle dispersions tend to cause deterioration in bonding strength of the resulting bonded body in some cases according to the time period of storage of the copper fine particle dispersions. It has been difficult to use such copper fine particle dispersions that are thus deteriorated in storage stability, for mounting respective elements in the power devices.

In the case where the copper paste described in the Patent Literature 1 in which the copper fine particles whose surface is treated with hydrophobic lauric acid are dispersed with the hydrophilic polyethylene glycol, is used to produce the bonded body after storing the copper paste for one month, the resulting bonded body tends to suffer from deterioration in bonding strength. It is considered that the deteriorated bonding strength is caused by poor dispersibility of the copper paste.

In addition, the aqueous dispersion of the copper nanoparticles described in the Patent Literature 2 has posed such a problem that
since removal of polyvinyl pyrrolidone and polyvinyl alcohol used for protecting the copper fine particles upon firing is insufficient, the resulting bonded body tends to be deteriorated in bonding strength.

For these reasons, it has been required to further improve storage stability and bonding properties of the conventional copper fine particle dispersions.

The present invention relates to a copper fine particle dispersion that can be used for obtaining a bonded body that is improved in bonding strength even after storing the copper fine particle dispersion for a predetermined period of time, and a method for producing a bonded body using the copper fine particle dispersion.

The present inventors have found that in a copper fine particle dispersion that contains copper nanoparticles A, a carboxylic acid B having not less than 6 and not more than 14 carbon atoms, a compound C represented by the formula of RO-(CH₂CH₂O)ₙ-CH₂-COOH, and a dispersion medium D that contains at least one compound selected from the group consisting of a (poly)alkylene glycol, a (poly)alkylene glycol derivative, a terpene alcohol, glycerin and a glycerin derivative, when controlling a content of the carboxylic acid B, a content of the compound C and a total content of the carboxylic acid B and the compound in the dispersion to respective predetermined ranges, it is possible to provide a copper fine particle dispersion that is improved in dispersion stability, storage stability and sintering properties under low-temperature conditions, and can be used for obtaining a bonded body that is improved in bonding strength even after storing the copper fine particle dispersion for a predetermined period of time, and also provide a method for producing a bonded body using the copper fine particle dispersion.

That is, the present invention relates to the following aspects [1] and [2].
[1] A copper fine particle dispersion containing copper nanoparticles A, a carboxylic acid B having not less than 6 and not more than 14 carbon atoms, a compound C represented by the formula (1):

   RO-(CH₂CH₂O)ₙ-CH₂-COOH (1)

   wherein R is a hydrocarbon group having not less than 6 and not more than 14 carbon atoms; and n represents an average molar number of addition of ethyleneoxy groups, and is a number of not less than 0.5 and not more than 20,
   and a dispersion medium D, in which:
      the dispersion medium D contains at least one compound selected from the group consisting of a (poly)alkylene glycol, a (poly)alkylene glycol derivative, a terpene alcohol, glycerin and a glycerin derivative;
      a content of the carboxylic acid B in the dispersion is not less than 0.1% by mass;
      a content of the compound C in the dispersion is not less than 0.05% by mass; and
      a total content of the carboxylic acid B and the compound C in the dispersion is not more than 8% by mass.
[2] A method for producing a bonded body, including the steps of allowing the copper fine particle dispersion according to the above aspect [1] to intervene between a plurality of metal members; and heating the dispersion between the plurality of metal members.

In accordance with the present invention, it is possible to provide a copper fine particle dispersion that can be used for obtaining a bonded body that is improved in bonding strength even after storing the copper fine particle dispersion for a predetermined period of time, and a method for producing a bonded body using the copper fine particle dispersion.

### [Copper Fine Particle Dispersion]

The copper fine particle dispersion according to the present invention contains copper nanoparticles A, a carboxylic acid B having not less than 6 and not more than 14 carbon atoms, a compound C represented by the formula (1):

RO-(CH₂CH₂O)ₙ-CH₂-COOH (1)

wherein R is a hydrocarbon group having not less than 6 and not more than 14 carbon atoms; and n represents an average molar number of addition of ethyleneoxy groups, and is a number of not less than 0.5 and not more than 20,
and a dispersion medium D, in which:
   the dispersion medium D contains at least one compound selected from the group consisting of a (poly)alkylene glycol, a (poly)alkylene glycol derivative, a terpene alcohol, glycerin and a glycerin derivative;
   a content of the carboxylic acid B in the dispersion is not less than 0.1% by mass;
   a content of the compound C in the dispersion is not less than 0.05% by mass; and
   a total content of the carboxylic acid B and the compound C in the dispersion is not more than 8% by mass.
   Incidentally, in the present specification, the "sintering properties under low-temperature conditions" mean that sintering of metal is caused in a low-temperature nitrogen atmosphere, and is hereinafter also referred to as "low-temperature sintering properties". In addition, bonding properties between a plurality of metal members in a low-temperature nitrogen atmosphere are hereinafter also referred to as "low-temperature bonding properties". Besides, the low-temperature bonding properties after storing the copper fine particle dispersion, for example, under the conditions of a temperature of 25 °C and a humidity of 50% for one month is hereinafter also referred to as "low-temperature bonding properties after storage".

Furthermore, in the present specification, the "low temperature" means that the temperature is lower than an ordinary sintering temperature when using a silver nanoparticle dispersion (from about 250 °C to about 300 °C), for example, it means the temperature range of from about 100 °C to about 230 °C. It is preferred that the copper fine particle dispersion be improved in sintering properties and bonding properties at a lower temperature.

According to the present invention, it is possible to exhibit such an advantageous effect that a bonded body having improved bonding strength can be obtained using the copper fine particle dispersion even after storing the dispersion for a predetermined period of time. The reason why the aforementioned advantageous effect can be attained by the present invention is considered as follows, though it is not clearly determined yet.

That is, it is considered that the copper nanoparticles A contained in the copper fine particle dispersion according to the present invention are dispersed in the dispersion medium D that contains at least one compound selected from the group consisting of a (poly)alkylene glycol, a (poly)alkylene glycol derivative, a terpene alcohol, glycerin and a glycerin derivative, with the carboxylic acid B having not less than 6 and not more than 14 carbon atoms and the compound C represented by the aforementioned formula (1).

The carboxylic acid B having not less than 6 and not more than 14 carbon atoms shows good coordination to the copper nanoparticles A, but has strong hydrophobic properties. Therefore, it is considered that the copper nanoparticles A to which the carboxylic acid B is coordinated tends to be deteriorated in dispersibility in the hydrophilic dispersion medium D. Meanwhile, in the compound C that contains the hydrocarbon group having not less than 6 and not more than 14 carbon atoms, the carboxy group and the ethyleneoxy group, since the hydrophilic groups and hydrophobic groups are allowed to be present therein in a well-balanced condition, it is considered that the compound C can exhibit good compatibility with each of the hydrophobic carboxylic acid B and the hydrophilic dispersion medium D. For this reason, it is considered that by using the combination of the carboxylic acid B having not less than 6 and not more than 14 carbon atoms and the compound C represented by the aforementioned formula (1) in order to disperse the copper nanoparticles A in the dispersion medium D, the copper nanoparticles A to which the carboxylic acid B is coordinated can be effectively improved in dispersibility in the dispersion medium D, so that the resulting copper fine particle dispersion can be improved in dispersion stability and storage stability.

In addition, the carboxylic acid B having not less than 6 and not more than 14 carbon atoms is a low-molecular weight ligand and therefore tends to be easily volatilized, and further the ethyleneoxy group of the compound C tends to be readily decomposed even at a low temperature in the presence of the copper nanoparticles A. For this reason, when subjecting the copper nanoparticles A to sintering, the carboxylic acid B and the compound C do not disturb the bonding between the metal members. Therefore, it is considered that since the copper nanoparticles A come close to each other even in a low-temperature nitrogen atmosphere, the copper fine particle dispersion can be improved in low-temperature sintering properties and low-temperature bonding properties.

For the aforementioned reasons, it is considered that according to the present invention, since the copper fine particle dispersion can be improved not only in dispersion stability and storage stability, but also in low-temperature sintering properties and low-temperature bonding properties, it is possible to obtain a bonded body that can be improved in bonding strength even after storing the copper fine particle dispersion for a predetermined period of time.

### <Copper Nanoparticles A>

The copper fine particle dispersion according to the present invention contains nanoparticles A of copper (hereinafter also referred to as "copper nanoparticles A").

The content of copper in the copper nanoparticles A is preferably not less than 95% by mass, more preferably not less than 98% by mass, even more preferably not less than 99% by mass and further even more preferably substantially 100% by mass from the viewpoint of improving electrical conductivity, low-temperature sintering properties, low-temperature bonding properties, and low-temperature bonding properties after storage of the copper fine particle dispersion.

Meanwhile, the "substantially 100% by mass" as used above means that the copper nanoparticles A may contain unintended components. Examples of the unintended components include unavoidable impurities.

The average particle size of the copper nanoparticles A is preferably not less than 100 nm, more preferably not less than 130 nm, even more preferably not less than 150 nm and further even more preferably not less than 170 nm from the viewpoint of improving dispersion stability of the copper fine particle dispersion, and is also preferably not more than 350 nm, more preferably not more than 320 nm, even more preferably not more than 300 nm and further even more preferably not more than 280 nm from the viewpoint of improving low-temperature sintering properties, low-temperature bonding properties, and low-temperature bonding properties after storage of the copper fine particle dispersion.

The average particle size of the copper nanoparticles A may be measured by the method described in Examples below.

The average particle size of the copper nanoparticles A may be controlled by varying production conditions of the copper nanoparticles A, such as a reduced metal ratio, the kind and amount of the carboxylic acid B used, a reduction temperature, etc., and the like.

The content of the copper nanoparticles A in the copper fine particle dispersion according to the present invention is preferably more than 25% by mass, more preferably not less than 30% by mass, even more preferably not less than 40% by mass, further even more preferably not less than 50% by mass and still further even more preferably not less than 55% by mass from the viewpoint of improving low-temperature sintering properties, low-temperature bonding properties, and low-temperature bonding properties after storage of the copper fine particle dispersion, and is also preferably less than 97% by mass, more preferably not more than 96% by mass, even more preferably not more than 93% by mass and further even more preferably not more than 91% by mass from the viewpoint of improving dispersion stability of the copper fine particle dispersion. When comprehensively taking these viewpoints into consideration, the content of the copper nanoparticles A in the copper fine particle dispersion according to the present invention is preferably more than 25% by mass and less than 97% by mass, more preferably not less than 30% by mass and not more than 96% by mass, even more preferably not less than 40% by mass and not more than 93% by mass, further even more preferably not less than 50% by mass and not more than 91% by mass, and still further even more preferably not less than 55% by mass and not more than 91% by mass.

### <Carboxylic Acid B>

The copper nanoparticles A according to the present invention are dispersed in the copper fine particle dispersion with the carboxylic acid B having not less than 6 and not more than 14 carbon atoms from the viewpoint of improving dispersion stability of the copper fine particle dispersion, and improving low-temperature sintering properties, low-temperature bonding properties, and low-temperature bonding properties after storage of the copper fine particle dispersion.

The number of carbon atoms contained in the carboxylic acid B is not less than 6 and not more than 14, preferably not less than 6 and not more than 12, more preferably not less than 6 and not more than 10, and even more preferably not less than 6 and not more than 8 from the viewpoint of improving dispersion stability of the copper fine particle dispersion, and improving low-temperature sintering properties, low-temperature bonding properties, and low-temperature bonding properties after storage of the copper fine particle dispersion.

As the carboxylic acid B, there may be used both of a linear carboxylic acid and a branched carboxylic acid. Among these carboxylic acids, preferred is the linear carboxylic acid from the viewpoint of improving dispersion stability of the copper fine particle dispersion, and improving low-temperature sintering properties, low-temperature bonding properties, and low-temperature bonding properties after storage of the copper fine particle dispersion.

Also, as the carboxylic acid B, there may be used any of a saturated carboxylic acid and an unsaturated carboxylic acid. Among these carboxylic acids, from the viewpoint of ensuring good availability, preferred is the saturated carboxylic acid, more preferred is a saturated aliphatic carboxylic acid, and even more preferred is a saturated aliphatic monovalent carboxylic acid.

As the saturated aliphatic monovalent carboxylic acid, from the viewpoint of improving dispersion stability of the copper fine particle dispersion, and improving low-temperature sintering properties, low-temperature bonding properties, and low-temperature bonding properties after storage of the copper fine particle dispersion, preferred is at least one carboxylic acid selected from the group consisting of hexanoic acid, caprylic acid, capric acid, lauric acid and myristic acid, more preferred is at least one carboxylic acid selected from the group consisting of hexanoic acid, caprylic acid, capric acid and lauric acid, even more preferred is at least one carboxylic acid selected from the group consisting of hexanoic acid, caprylic acid and capric acid, and further even more preferred is at least one carboxylic acid selected from the group consisting of hexanoic acid and caprylic acid.

The content of the carboxylic acid B in the copper fine particle dispersion according to the present invention is not less than 0.1% by mass, preferably not less than 0.3% by mass, more preferably not less than 0.5% by mass and even more preferably not less than 0.6% by mass from the viewpoint of improving dispersion stability of the copper fine particle dispersion, and improving low-temperature sintering properties, low-temperature bonding properties, and low-temperature bonding properties after storage of the copper fine particle dispersion, and is also preferably not more than 7.5% by mass, more preferably not more than 6% by mass, even more preferably not more than 5% by mass and further even more preferably not more than 4% by mass from the viewpoint of improving dispersion stability of the copper fine particle dispersion, and improving low-temperature sintering properties, low-temperature bonding properties, and low-temperature bonding properties after storage of the copper fine particle dispersion. When comprehensively taking these viewpoints into consideration, the content of the carboxylic acid B in the copper fine particle dispersion according to the present invention is preferably not less than 0.1% by mass and not more than 7.5% by mass, more preferably not less than 0.3% by mass and not more than 6% by mass, even more preferably not less than 0.3% by mass and not more than 5% by mass, further even more preferably not less than 0.5% by mass and not more than 4% by mass, and still further even more preferably not less than 0.6% by mass and not more than 4% by mass.

### <Compound C>

From the viewpoint of improving dispersion stability of the copper fine particle dispersion, and improving low-temperature sintering properties, low-temperature bonding properties, and low-temperature bonding properties after storage of the copper fine particle dispersion, the copper fine particle dispersion according to the present invention contains the compound C represented by the following formula (1):

RO-(CH₂CH₂O)ₙ-CH₂-COOH (1)

wherein R is a hydrocarbon group having not less than 6 and not more than 14 carbon atoms; and n represents an average molar number of addition of ethyleneoxy groups, and is a number of not less than 0.5 and not more than 20.

The number of carbon atoms contained in R in the formula (1) is not less than 6 and preferably not less than 8 from the viewpoint of improving dispersion stability of the copper fine particle dispersion, and improving low-temperature sintering properties, low-temperature bonding properties, and low-temperature bonding properties after storage of the copper fine particle dispersion, and is also not more than 14, preferably not more than 12, more preferably not more than 10 and even more preferably not more than 8 from the viewpoint of improving dispersion stability, low-temperature sintering properties, low-temperature bonding properties, and low-temperature bonding properties after storage of the copper fine particle dispersion.

The R group in the formula (1) may be either a linear group or a branched group. Among these groups, from the viewpoint of improving dispersion stability of the copper fine particle dispersion, and improving low-temperature sintering properties, low-temperature bonding properties, and low-temperature bonding properties after storage of the copper fine particle dispersion, the R group is preferably a linear group.

In addition, as the compound C, there may be used either a saturated compound or an unsaturated compound. However, from the viewpoint of ensuring good availability, the compound C is preferably in the form of a saturated compound.

The suffix n in the formula (1) is not less than 0.5, preferably not less than 2, more preferably not less than 4 and even more preferably not less than 6 from the viewpoint of improving dispersion stability of the copper fine particle dispersion, and improving low-temperature sintering properties, low-temperature bonding properties, and low-temperature bonding properties after storage of the copper fine particle dispersion, and is also not more than 20, preferably not more than 15, more preferably not more than 12 and even more preferably not more than 10 from the viewpoint of improving dispersion stability, low-temperature sintering properties, low-temperature bonding properties, and low-temperature bonding properties after storage of the copper fine particle dispersion. When comprehensively taking these viewpoints into consideration, the suffix n in the formula (1) is not less than 0.5 and not more than 20, preferably not less than 2 and not more than 15, more preferably not less than 4 and not more than 12, and even more preferably not less than 6 and not more than 10.

From the viewpoint of improving dispersion stability of the copper fine particle dispersion, and improving low-temperature sintering properties, low-temperature bonding properties, and low-temperature bonding properties after storage of the copper fine particle dispersion, as well as from the viewpoint of ensuring good availability, the compound C is preferably a compound represented by the formula (1) in which R is a linear saturated alkyl group having not less than 6 and not more than 14 carbon atoms, and n is a number of not less than 0.5 and not more than 20, more preferably a compound represented by the formula (1) in which R is a linear saturated alkyl group having not less than 6 and not more than 14 carbon atoms, and n is a number of not less than 4 and not more than 12, even more preferably a compound represented by the formula (1) in which R is a linear saturated alkyl group having not less than 8 and not more than 12 carbon atoms, and n is a number of not less than 6 and not more than 10, and further even more preferably a compound represented by the formula (1) in which R is a linear saturated alkyl group having 8 carbon atoms, and n is a number of not less than 6 and not more than 10.

The content of the compound C in the copper fine particle dispersion according to the present invention is not less than 0.05% by mass, preferably not less than 0.1% by mass, more preferably not less than 0.3% by mass and even more preferably not less than 0.5% by mass from the viewpoint of improving dispersion stability of the copper fine particle dispersion, and improving low-temperature sintering properties, low-temperature bonding properties, and low-temperature bonding properties after storage of the copper fine particle dispersion, and is also preferably not more than 7.5% by mass, more preferably not more than 6% by mass, even more preferably not more than 5% by mass, further even more preferably not more than 3.5% by mass, still further even more preferably not more than 2.5% by mass, still further even more preferably not more than 2% by mass and yet still further even more preferably not more than 1.5% by mass from the viewpoint of improving dispersion stability of the copper fine particle dispersion, and improving low-temperature sintering properties, low-temperature bonding properties, and low-temperature bonding properties after storage of the copper fine particle dispersion. When comprehensively taking these viewpoints into consideration, the content of the compound C in the copper fine particle dispersion according to the present invention is preferably not less than 0.05% by mass and not more than 7.5% by mass, more preferably not less than 0.05% by mass and not more than 6% by mass, even more preferably not less than 0.1% by mass and not more than 5% by mass, further even more preferably not less than 0.3% by mass and not more than 3.5% by mass, still further even more preferably not less than 0.5% by mass and not more than 2.5% by mass, still further even more preferably not less than 0.5% by mass and not more than 2% by mass, and yet still further even more preferably not less than 0.5% by mass and not more than 1.5% by mass.

The total content of the carboxylic acid B and the compound C in the copper fine particle dispersion according to the present invention is preferably not less than 0.85% by mass, more preferably not less than 1% by mass, even more preferably not less than 1.3% by mass and further even more preferably not less than 1.5% by mass from the viewpoint of improving dispersion stability of the copper fine particle dispersion, and improving low-temperature sintering properties, low-temperature bonding properties, and low-temperature bonding properties after storage of the copper fine particle dispersion, and is also not more than 8% by mass, preferably not more than 7% by mass, more preferably not more than 5% by mass, even more preferably not more than 4.5% by mass and further even more preferably not more than 3% by mass from the viewpoint of improving dispersion stability of the copper fine particle dispersion, and improving low-temperature sintering properties, low-temperature bonding properties, and low-temperature bonding properties after storage of the copper fine particle dispersion. When comprehensively taking these viewpoints into consideration, the total content of the carboxylic acid B and the compound C in the copper fine particle dispersion according to the present invention is preferably not less than 0.85% by mass and not more than 8% by mass, more preferably not less than 0.85% by mass and not more than 7% by mass, even more preferably not less than 1% by mass and not more than 5% by mass, further even more preferably not less than 1.3% by mass and not more than 4.5% by mass, and still further even more preferably not less than 1.5% by mass and not more than 3% by mass.

The mass ratio of the content of the compound C to the content of the carboxylic acid B in the copper fine particle dispersion according to the present invention is preferably not less than 0.05, more preferably not less than 0.1, even more preferably not less than 0.25, further even more preferably not less than 0.3 and still further even more preferably not less than 0.4 from the viewpoint of improving dispersion stability of the copper fine particle dispersion, and improving low-temperature sintering properties, low-temperature bonding properties, and low-temperature bonding properties after storage of the copper fine particle dispersion, and is also preferably not more than 9, more preferably not more than 7.5, even more preferably not more than 7, further even more preferably not more than 6.2, still further even more preferably not more than 4, still further even more preferably not more than 3.1 and yet still further even more preferably not more than 0.8 from the viewpoint of improving dispersion stability of the copper fine particle dispersion, and improving low-temperature sintering properties, low-temperature bonding properties, and low-temperature bonding properties after storage of the copper fine particle dispersion. When comprehensively taking these viewpoints into consideration, the mass ratio of the content of the compound C to the content of the carboxylic acid B in the copper fine particle dispersion according to the present invention is preferably not less than 0.05 and not more than 9, more preferably not less than 0.05 and not more than 7, even more preferably not less than 0.1 and not more than 6.2, further even more preferably not less than 0.25 and not more than 4, still further even more preferably not less than 0.3 and not more than 3.1, and yet still further even more preferably not less than 0.4 and not more than 0.8.

### <Dispersion Medium D>

The copper fine particle dispersion according to the present invention contains the dispersion medium D from the viewpoint of improving dispersion stability of the copper fine particle dispersion, and improving storage stability and low-temperature bonding properties after storage of the copper fine particle dispersion.

The dispersion medium D contains at least one compound selected from the group consisting of a (poly)alkylene glycol, a (poly)alkylene glycol derivative, a terpene alcohol, glycerin (boiling point: 290 °C; molecular weight: 92) and a glycerin derivative from the viewpoint of improving dispersion stability of the copper fine particle dispersion, and improving storage stability and low-temperature bonding properties after storage of the copper fine particle dispersion.

Examples of the (poly)alkylene glycol include ethylene glycol (boiling point: 197 °C; molecular weight: 62), propylene glycol (boiling point: 188 °C; molecular weight: 76), diethylene glycol (boiling point: 244 °C; molecular weight: 106), triethylene glycol (boiling point: 287 °C; molecular weight: 150), tetraethylene glycol (boiling point: 327 °C; molecular weight: 194), dipropylene glycol (boiling point: 232 °C; molecular weight: 134), tripropylene glycol (boiling point: 273 °C; molecular weight: 192), tetrapropylene glycol (boiling point: not lower than 300 °C; molecular weight: 250), polyethylene glycol (number-average molecular weight: preferably not less than 100 and not more than 1000, more preferably not less than 150 and not more than 600, and even more preferably not less than 180 and not more than 500), polypropylene glycol (number-average molecular weight: preferably not less than 150 and not more than 1000, more preferably not less than 180 and not more than 600, and even more preferably not less than 200 and not more than 500), 2-ethyl-1,3-hexanediol (boiling point: 244 °C; molecular weight: 146), and the like.

Examples of the (poly)alkylene glycol derivative include those compounds obtained by etherifying or esterifying terminal hydroxy groups of the aforementioned (poly)alkylene glycol, and the like.

Examples of the compounds obtained by etherifying or esterifying both of the terminal hydroxy groups of the aforementioned (poly)alkylene glycol include diethylene glycol dimethyl ether (boiling point: 162 °C; molecular weight: 134), diethylene glycol dibutyl ether (boiling point: 254 °C; molecular weight: 218), triethylene glycol dimethyl ether (boiling point: 216 °C; molecular weight: 178), diethylene glycol monoethyl ether acetate (boiling point: 217 °C; molecular weight: 176), diethylene glycol monobutyl ether acetate (boiling point: 247 °C; molecular weight: 204), and the like.

Examples of the compounds obtained by etherifying or esterifying one of the terminal hydroxy groups of the aforementioned (poly)alkylene glycol include diethylene glycol monoethyl ether (boiling point: 202 °C; molecular weight: 134), diethylene glycol monobutyl ether (boiling point: 231 °C; molecular weight: 162), and the like.

Examples of the terpene alcohol include monoterpene alcohols, such as □-terpineol (boiling point: 219 °C; molecular weight: 154), linalol (boiling point: 198 °C; molecular weight: 154), geraniol (boiling point: 229 °C; molecular weight: 154), citronellol (boiling point: 225 °C; molecular weight: 156), etc.

The glycerin derivative is not particularly limited as long as it is, for example, in the form of a solvent having a structure derived from glycerin. Examples of the glycerin derivative include ether derivatives of glycerin, ester derivatives of glycerin, polyglycerin, alkyleneoxide adducts (for example, ethyleneoxide adducts or propyleneoxide adducts) of glycerin, and the like. Examples of the polyglycerin include diglycerin, triglycerin, and the like. Examples of commercially available products of the polyglycerin include "Polyglycerin #310", "Polyglycerin #500" and "Polyglycerin #750" all available from Sakamoto Yakuhin Kogyo Co., Ltd., and the like. Examples of the ether derivatives of glycerin include 3-(2-ethylhexyloxy)-1,2-propanediol (boiling point: 325 °C; molecular weight: 204), and the like. Examples of the ester derivatives of glycerin include glyceryl tributyrate (boiling point: 305 °C; molecular weight: 302), and the like.

From the viewpoint of improving dispersion stability of the copper fine particle dispersion, and improving storage stability and low-temperature bonding properties after storage of the copper fine particle dispersion, the dispersion medium D preferably contains at least one compound selected from the group consisting of the (poly)alkylene glycol, the (poly)alkylene glycol derivative and the terpene alcohol, more preferably at least one compound selected from the group consisting of dipropylene glycol, tetraethylene glycol, polyethylene glycol (number-average molecular weight: preferably not less than 100 and not more than 1000, more preferably not less than 150 and not more than 600, and even more preferably not less than 180 and not more than 500), □-terpineol and diethylene glycol monobutyl ether, and even more preferably at least one compound selected from the group consisting of dipropylene glycol, tetraethylene glycol, polyethylene glycol (number-average molecular weight: not less than 180 and not more than 500), □-terpineol and diethylene glycol monobutyl ether.

The boiling point of the dispersion medium D as measured at 1 atm is preferably not lower than 180 °C, more preferably not lower than 200 °C, even more preferably not lower than 210 °C, further even more preferably not lower than 220 °C and still further even more preferably not lower than 225 °C from the viewpoint of improving storage stability and low-temperature bonding properties after storage of the copper fine particle dispersion, and is also preferably not higher than 400 °C, more preferably not higher than 360 °C, even more preferably not higher than 330 °C and further even more preferably not higher than 310 °C from the viewpoint of improving low-temperature sintering properties, low-temperature bonding properties, and low-temperature bonding properties after storage of the copper fine particle dispersion. Incidentally, in the case where two or more dispersion media are used as the dispersion medium D, the boiling point of the dispersion medium D is a weighted mean value of boiling points of the two or more dispersion media which are weighted by contents (% by mass) of the respective dispersion media.

The molecular weight of the dispersion medium D is preferably not less than 60, more preferably not less than 100, even more preferably not less than 110 and further even more preferably not less than 130 from the viewpoint of improving storage stability and low-temperature bonding properties after storage of the copper fine particle dispersion, and is also preferably not more than 600, more preferably not more than 450, even preferably not more than 400, further even preferably not more than 350 and still further even preferably not more than 330 from the viewpoint of improving low-temperature sintering properties, low-temperature bonding properties, and low-temperature bonding properties after storage of the copper fine particle dispersion. In the case where two or more dispersion media are used as the dispersion medium D, the molecular weight of the dispersion medium D is a weighted mean value of molecular weights of the two or more dispersion media which are weighted by contents (% by mass) of the respective dispersion media.

The total content of the (poly)alkylene glycol, the (poly)alkylene glycol derivative, the terpene alcohol, glycerin and the glycerin derivative (these compounds are hereinafter also collectively referred to as a "dispersion medium D1") in the dispersion medium D is preferably not less than 50% by mass, more preferably not less than 70% by mass, even more preferably not less than 80% by mass, further even more preferably not less than 90% by mass, still further even more preferably not less than 95% by mass, still further even more preferably not less than 98% by mass, still further even more preferably not less than 99% by mass, still further even more preferably not less than 99.9% by mass and yet still further even more preferably substantially 100% by mass from the viewpoint of improving storage stability and low-temperature bonding properties after storage of the copper fine particle dispersion. Meanwhile, the expression "substantially 100% by mass" as used above means that the dispersion medium may contain unintended components. Examples of the unintended components include those dispersion media D other than the aforementioned dispersion medium D1, which may be contained in the dispersion medium D1.

The total content of the (poly)alkylene glycol, the (poly)alkylene glycol derivative and the terpene alcohol (these compounds are hereinafter also collectively referred to as a "dispersion medium D2") in the dispersion medium D is preferably not less than 50% by mass, more preferably not less than 70% by mass, even more preferably not less than 80% by mass, further even more preferably not less than 90% by mass, still further even more preferably not less than 95% by mass, still further even more preferably not less than 98% by mass, still further even more preferably not less than 99% by mass, still further even more preferably not less than 99.9% by mass and yet still further even more preferably substantially 100% by mass from the viewpoint of improving storage stability and low-temperature bonding properties after storage of the copper fine particle dispersion. Meanwhile, the expression "substantially 100% by mass" as used above means that the dispersion medium may contain unintended components. Examples of the unintended components include those dispersion media D other than the aforementioned dispersion medium D2, which may be contained in the dispersion medium D2.

The total content of dipropylene glycol, tetraethylene glycol, polyethylene glycol (number-average molecular weight: not less than 180 and not more than 500), □-terpineol and diethylene glycol monobutyl ether (these compounds are hereinafter also collectively referred to as a "dispersion medium D3") in the dispersion medium D is preferably not less than 50% by mass, more preferably not less than 70% by mass, even more preferably not less than 80% by mass, further even more preferably not less than 90% by mass, still further even more preferably not less than 95% by mass, still further even more preferably not less than 98% by mass, still further even more preferably not less than 99% by mass, still further even more preferably not less than 99.9% by mass and yet still further even more preferably substantially 100% by mass from the viewpoint of improving storage stability and low-temperature bonding properties after storage of the copper fine particle dispersion. Meanwhile, the expression "substantially 100% by mass" as used above means that the dispersion medium may contain unintended components. Examples of the unintended components include those dispersion media D other than the aforementioned dispersion medium D3, which may be contained in the dispersion medium D3.

The content of the dispersion medium D in the copper fine particle dispersion according to the present invention is preferably not less than 3% by mass, more preferably not less than 4% by mass, even more preferably not less than 6% by mass, further even more preferably not less than 6.5% by mass and still further even more preferably not less than 7.5% by mass from the viewpoint of improving dispersion stability of the copper fine particle dispersion, and improving storage stability and low-temperature bonding properties after storage of the copper fine particle dispersion, and is also preferably less than 10% by mass, more preferably not more than 9.9% by mass, even more preferably not more than 9.5% by mass, further even more preferably not more than 9% by mass and still further even more preferably not more than 8.5% by mass from the viewpoint of improving dispersion stability of the copper fine particle dispersion, and improving storage stability and low-temperature bonding properties after storage of the copper fine particle dispersion. When comprehensively taking these viewpoints into consideration, the content of the dispersion medium D in the copper fine particle dispersion according to the present invention is preferably not less than 3% by mass and less than 10% by mass, more preferably not less than 4% by mass and not more than 9.9% by mass, even more preferably not less than 6% by mass and not more than 9.5% by mass, further even more preferably not less than 6.5% by mass and not more than 9% by mass, and still further even more preferably not less than 7.5% by mass and not more than 8.5% by mass.

The content of water in the copper fine particle dispersion according to the present invention is preferably not more than 5% by mass, more preferably not more than 1% by mass, even more preferably not more than 0.5% by mass, further even more preferably not more than 0.1% by mass and still further even more preferably not more than 0.01% by mass from the viewpoint of inhibiting oxidation of copper as well as from the viewpoint of improving storage stability and low-temperature bonding properties after storage of the copper fine particle dispersion.

### <Copper Microparticles>

The copper fine particle dispersion according to the present invention may further contain copper microparticles from the viewpoint of improving electrical conductivity, low-temperature sintering properties, low-temperature bonding properties, and low-temperature bonding properties after storage of the copper fine particle dispersion.

The content of copper in the copper microparticles is preferably not less than 95% by mass, more preferably not less than 98% by mass, even more preferably not less than 99% by mass and further even more preferably substantially 100% by mass from the viewpoint of improving electrical conductivity, low-temperature sintering properties, low-temperature bonding properties, and low-temperature bonding properties after storage of the copper fine particle dispersion.

Meanwhile, the expression "substantially 100% by mass" as used above means that the copper microparticles may contain unintended components. Examples of the unintended components include unavoidable impurities.

The average particle size of the copper microparticles is preferably more than 0.35 µm, more preferably not less than 0.5 µm, even more preferably not less than 0.7 µm, further even more preferably not less than 0.8 µm and still further even more preferably not less than 0.9 µm from the viewpoint of improving electrical conductivity, low-temperature sintering properties, low-temperature bonding properties, and low-temperature bonding properties after storage of the copper fine particle dispersion, and is also preferably not more than 10 µm, more preferably not more than 7 µm, even more preferably not more than 5 µm, further even more preferably not more than 3 µm and still further even more preferably not more than 2 µm from the viewpoint of improving dispersion stability and storage stability of the copper fine particle dispersion as well as low-temperature bonding properties after storage of the copper fine particle dispersion.

The average particle size of the copper microparticles may be measured by the method described in Examples below.

The content of the copper microparticles in the copper fine particle dispersion according to the present invention is preferably not less than 5% by mass, more preferably not less than 15% by mass, even more preferably not less than 20% by mass and further even more preferably not less than 25% by mass from the viewpoint of improving electrical conductivity, low-temperature sintering properties, low-temperature bonding properties, and low-temperature bonding properties after storage of the copper fine particle dispersion, and is also preferably not more than 65% by mass, more preferably not more than 55% by mass, even more preferably not more than 45% by mass and further even more preferably not more than 35% by mass from the viewpoint of improving electrical conductivity and dispersion stability of the copper fine particle dispersion, as well as storage stability, low-temperature sintering properties, low-temperature bonding properties, and low-temperature bonding properties after storage of the copper fine particle dispersion.

The mass ratio of the content of the copper nanoparticles A to a total content of the copper nanoparticles A and the copper microparticles [copper nanoparticles A/(copper nanoparticles A + copper microparticles)] in the copper fine particle dispersion according to the present invention is preferably not less than 0.3, more preferably not less than 0.4, even more preferably not less than 0.5 and further even more preferably not less than 0.6 from the viewpoint of improving electrical conductivity, and storage stability, low-temperature sintering properties, low-temperature bonding properties, and low-temperature bonding properties after storage of the copper fine particle dispersion, and is also preferably not more than 1.0, more preferably not more than 0.9, even more preferably not more than 0.8 and further even more preferably not more than 0.75 from the viewpoint of improving electrical conductivity, low-temperature sintering properties, low-temperature bonding properties, and low-temperature bonding properties after storage of the copper fine particle dispersion.

### (Composition of Copper Fine Particle Dispersion)

In the copper fine particle dispersion according to the present invention, from the viewpoint of improving dispersion stability of the copper fine particle dispersion, and improving storage stability, electrical conductivity, low-temperature sintering properties, low-temperature bonding properties, and low-temperature bonding properties after storage of the copper fine particle dispersion, the content of the copper nanoparticles A therein is preferably more than 25% by mass and less than 97% by mass, the content of the carboxylic acid B therein is preferably not less than 0.1% by mass and not more than 7.5% by mass, the content of the compound C therein is preferably not less than 0.05% by mass and not more than 7.5% by mass, the content of the dispersion medium D therein is preferably not less than 3% by mass and less than 10% by mass, and the content of the copper microparticles therein is preferably not less than 0% by mass and not more than 65% by mass.

The copper fine particle dispersion according to the present invention may also contain various additives as additional components other than the aforementioned components unless the advantageous effects of the present invention are adversely affected by inclusion of these additives. Examples of the additives include metal particles other than the copper nanoparticles A and the copper microparticles, a sintering accelerator, such as glass frits, etc., an antioxidant, a viscosity modifier, a pH controller, a buffer, a defoaming agent, a leveling agent, a volatilization inhibitor, and the like. Examples of the metal particles other than the copper nanoparticles A and the copper microparticles include particles of metal, such as zinc, nickel, silver, gold, palladium, platinum, etc.

The content of the additives in the copper fine particle dispersion according to the present invention is preferably not more than 1% by mass.

### (Production of Copper Fine Particle Dispersion)

The copper fine particle dispersion according to the present invention may be obtained by the method in which the carboxylic acid B, the compound C and the dispersion medium D, and further, if required, the copper microparticles, various additives, etc., are added to and mixed with the copper nanoparticles A previously prepared by conventionally known methods; the method in which a copper raw material compound, a reducing agent and the carboxylic acid B, and further, if required, a solvent for dispersing the copper raw material compound and the reducing agent therein, are mixed with each other to subject the copper raw material compound to reduction reaction and thereby obtain a dispersion of the copper nanoparticles A, and then the compound C and the dispersion medium D, and further, if required, the carboxylic acid B, the copper microparticles, various additives, etc., are added to and mixed with the resulting dispersion of the copper nanoparticles A; and the like. Among these methods, from the viewpoint of improving dispersion stability of the copper fine particle dispersion, and improving storage stability and low-temperature bonding properties after storage of the copper fine particle dispersion, preferred is the method in which after previously obtaining a dry powder of the copper nanoparticles A containing the carboxylic acid B (hereinafter also referred to as "a copper nanoparticle dry powder"), the compound C and the dispersion medium D, and further, if required, the carboxylic acid B, the copper microparticles, various additives, etc., are added to and mixed with the resulting dry powder.

The copper nanoparticle dry powder may be obtained by mixing the copper raw material compound, the reducing agent and the carboxylic acid B with each other to reduce the copper raw material compound with the reducing agent and thereby obtain a dispersion of the copper nanoparticles A that are dispersed therein with the carboxylic acid B, and then drying the dispersion of the copper nanoparticles A by a freeze-drying method, etc.

The copper raw material compound is not particularly limited as long as it is a compound containing copper.

Examples of the copper raw material compound include copper sulfate, copper nitrate, cupric oxide, cuprous oxide, copper formate, copper acetate, copper oxalate, and the like. These copper raw material compounds may be used alone or in the form of a mixture of any two or more thereof.

The reducing agent is not particularly limited as long as the reducing agent is a compound capable of reducing the copper raw material compound.

Examples of the reducing agent include hydrazine-based compounds, such as hydrazine, hydrazine hydrochloride, hydrazine sulfate, hydrazine hydrate, etc.; boron compounds, such as sodium boron hydride, etc.; inorganic acid salts, such as sodium sulfite, sodium hydrogen sulfite, sodium thiosulfate, sodium nitrite, sodium hyponitrite, phosphorous acid, sodium phosphite, hypophosphorous acid, sodium hypophosphite, etc.; and the like.

These reducing agents may be used alone or in combination of any two or more thereof.

Examples of the solvent for dispersing the copper raw material compound and the reducing agent in the dispersion include water, methanol, ethanol, propanol, butanol, ethylene glycol, propylene glycol, diethylene glycol, dipropylene glycol, and the like.

The temperature of the reduction reaction is preferably not lower than 5 °C, more preferably not lower than 10 °C, even more preferably not lower than 20 °C, further even more preferably not lower than 30 °C, still further even more preferably not lower than 50 °C and yet still further even more preferably not lower than 60 °C from the viewpoint of reducing a particle size of the respective copper nanoparticles A and rendering the particles uniform, and is also preferably not higher than 100 °C, more preferably not higher than 90 °C, even more preferably not higher than 80 °C and further even more preferably not higher than 75 °C from the viewpoint of stably producing the copper nanoparticles. The reduction reaction may be conducted either in an air atmosphere or in an atmosphere of inert gas, such as nitrogen gas, etc.

In the production of the copper fine particle dispersion, from the viewpoint of removing impurities, such as the unreacted reducing agent, a surplus of the carboxylic acid B which has no contribution to dispersion of the copper nanoparticles A, etc., the dispersion of the copper nanoparticles A may be subjected to purification treatment before subjecting the dispersion to freeze-drying.

The method of purifying the dispersion of the copper nanoparticles A is not particularly limited, and there may be used various methods including membrane treatment, such as dialysis, ultrafiltration, etc.; centrifugal separation treatment; and the like. Among these methods, from the viewpoint of efficiently removing the impurities from the dispersion, preferred is the membrane treatment, and more preferred is dialysis. As a material of a dialysis membrane used in the dialysis, there is preferably used a regenerated cellulose.

The molecular weight cut-off of the dialysis membrane is preferably not less than 1,000, more preferably not less than 5,000 and even more preferably not less than 10,000, and is also preferably not more than 100,000 and more preferably not more than 70,000, from the viewpoint of efficiently removing the impurities from the resulting dispersion.

The copper fine particle dispersion according to the present invention may be obtained by further adding the aforementioned various additives to the dispersion, if required, and then subjecting the dispersion to filtration treatment using a filter, etc.

The copper fine particle dispersion according to the present invention has good low-temperature sintering properties, good low-temperature bonding properties and good low-temperature bonding properties after storage, and therefore can be used for production of conductive members for various electronic and electrical equipments. The conductive members are preferably used in bonding agents, such as solder, etc.; antennas, such as RFID (radio frequency identifier) tags, etc.; capacitors, such as MLCC (multilayer ceramic capacitors), etc.; electronic paper; image display apparatuses, such as a liquid crystal display, an organic EL display, etc.; organic EL elements; organic transistors; wiring boards, such as printed wiring boards, flexible wiring boards, etc.; organic solar cells; sensors, such as flexible sensors, etc.; and the like. Among these applications, the copper fine particle dispersion according to the present invention is preferably used for bonding a plurality of metal members to each other from the viewpoint of efficiently exhibiting good low-temperature sintering properties, good low-temperature bonding properties and good low-temperature bonding properties after storage of the dispersion.

### [Method for Producing Bonded Body]

The method for producing a bonded body according to the present invention includes the steps of allowing a copper fine particle dispersion to intervene between a plurality of metal members, and heating the dispersion between the plurality of metal members. The copper fine particle dispersion used in the above method is the aforementioned copper fine particle dispersion according to the present invention.

In the case where the copper fine particle dispersion according to the present invention is used for bonding the plurality of metal members to each other, the copper fine particle dispersion is preferably used in the method for producing a bonded body which includes the steps of allowing the copper fine particle dispersion to intervene between the plurality of metal members, and heating the dispersion between the plurality of metal members.

The temperature of the heat treatment in the aforementioned heating step is preferably not lower than 100 °C, more preferably not lower than 150 °C and even more preferably not lower than 180 °C from the viewpoint of improving bonding strength and electrical conductivity of the resulting bonded body, and is also preferably not higher than 230 °C, more preferably not higher than 220 °C, even more preferably not higher than 210 °C and further even more preferably not higher than 205 °C from the viewpoint of improving low-temperature sintering properties and low-temperature bonding properties of the copper fine particle dispersion.

The heat treatment in the aforementioned heating step may be conducted either under no applied pressure or under applied pressure. However, from the viewpoint of improving bonding strength and electrical conductivity of the resulting bonded body, the heat treatment is preferably conducted under applied pressure. The pressure used in the heat treatment in the aforementioned heating step is preferably not less than 5 MPa, more preferably not less than 8 MPa, even more preferably not less than 10 MPa and further even more preferably not less than 15 MPa from the viewpoint of improving low-temperature sintering properties and low-temperature bonding properties of the copper fine particle dispersion, and is also preferably not more than 50 MPa, more preferably not more than 30 MPa, even more preferably not more than 25 MPa and further even more preferably not more than 20 MPa from the viewpoint of enhancing productivity of the bonded body.

The time of the heat treatment in the aforementioned heating step may be appropriately controlled according to the temperature and pressure used in the heat treatment.

The aforementioned heating step may be conducted in any of an air atmosphere, an atmosphere of inert gas, such as nitrogen gas, etc., and an atmosphere of a reducing gas, such as hydrogen gas, etc. However, from the viewpoint of inhibiting oxidation of copper and ensuring good safety, the heating step is preferably conducted in a nitrogen gas atmosphere.

Examples of the metal members to be bonded to each other in the present invention include metal-based substrates or substrates made of metal, such as a gold substrate, a gold-plated substrate, a silver substrate, a silver-plated metal substrate, a copper substrate, a palladium substrate, a palladium-plated metal substrate, a platinum substrate, a platinum-plated metal substrate, an aluminum substrate, a nickel substrate, a nickel-plated metal substrate, a tin substrate, a tin-plated metal substrate, etc.; a metal portion, such as an electrode, etc., of an electrically insulating substrate; and the like. The plurality of metal members used in the present invention may be constituted of either the same kind of metal member or different kinds of metal members.

Among them, the metal members preferably contain a least one member selected from the group consisting of a gold substrate, a gold-plated substrate, a silver substrate, a silver-plated metal substrate, a copper substrate, a palladium substrate, a palladium-plated metal substrate, a platinum substrate, a platinum-plated metal substrate, an aluminum substrate, a nickel substrate, a nickel-plated metal substrate, a tin substrate, a tin-plated metal substrate, and a metal portion of an electrically insulating substrate.

The bonding of the metal members in the present invention may be used for bonding between a chip element, such as a capacitor, a resistance, etc., and a circuit substrate; bonding between a semiconductor chip, such as a memory, a diode, a transistor, IC, CPU, etc., and a lead frame or a circuit substrate; bonding between a high heat generation semiconductor chip and a cooling plate; and the like.

As the method of applying the aforementioned copper fine particle dispersion to the metal members, there may be mentioned various coating methods, such as slot die coating, dip coating, spray coating, spin coating, doctor blading, knife edge coating, bar coating, etc.; and various pattern printing methods, such as stencil printing, screen printing, flexo printing, gravure printing, offset printing, dispenser printing, inkjet printing, etc.

The amount of the aforementioned copper fine particle dispersion applied to the metal members may be appropriately controlled according to sizes and kinds of metal members to be bonded to each other.

The bonding strength of the aforementioned bonded body is preferably not less than 10 MPa and more preferably not less than 15 MPa. The bonding strength may be measured by the method described in Examples below.

With respect to the aforementioned embodiments, the present invention further provides the following aspects.
<1> A copper fine particle dispersion containing copper nanoparticles A, a carboxylic acid B having not less than 6 and not more than 14 carbon atoms, a compound C represented by the formula (1):

   RO-(CH₂CH₂O)ₙ-CH₂-COOH (1)

   wherein R is a hydrocarbon group having not less than 6 and not more than 14 carbon atoms; and n represents an average molar number of addition of ethyleneoxy groups, and is a number of not less than 0.5 and not more than 20,
   and a dispersion medium D, in which:
      the dispersion medium D contains at least one compound selected from the group consisting of a (poly)alkylene glycol, a (poly)alkylene glycol derivative, a terpene alcohol, glycerin and a glycerin derivative;
      a content of the carboxylic acid B in the dispersion is not less than 0.1% by mass;
      a content of the compound C in the dispersion is not less than 0.05% by mass; and
      a total content of the carboxylic acid B and the compound C in the dispersion is not more than 8% by mass.
<2> The copper fine particle dispersion according to the above aspect <1> which contains the copper nanoparticles A, the carboxylic acid B having not less than 6 and not more than 14 carbon atoms, the compound C represented by the formula (1):

   RO-(CH₂CH₂O)ₙ-CH₂-COOH (1)

   wherein R is a hydrocarbon group having not less than 6 and not more than 14 carbon atoms; and n represents an average molar number of addition of ethyleneoxy groups, and is a number of not less than 0.5 and not more than 20,
   and the dispersion medium D, in which:
      the dispersion medium D contains at least one compound selected from the group consisting of a (poly)alkylene glycol, a (poly)alkylene glycol derivative, a terpene alcohol, glycerin and a glycerin derivative;
      a content of the copper nanoparticles A in the dispersion is more than 25% by mass and less than 97% by mass;
      the content of the carboxylic acid B in the dispersion is not less than 0.1% by mass and not more than 7.5% by mass;
      the content of the compound C in the dispersion is not less than 0.05% by mass and not more than 7.5% by mass;
      the total content of the carboxylic acid B and the compound C in the dispersion is not less than 0.85% by mass and not more than 8% by mass; and
      a boiling point of the dispersion medium D is not lower than 180 °C and not higher than 400 °C.
<3> The copper fine particle dispersion according to the above aspect <1> or <2> which contains the copper nanoparticles A, the carboxylic acid B having not less than 6 and not more than 14 carbon atoms, the compound C represented by the formula (1):

   RO-(CH₂CH₂O)ₙ-CH₂-COOH (1)

   wherein R is a hydrocarbon group having not less than 6 and not more than 14 carbon atoms; and n represents an average molar number of addition of ethyleneoxy groups, and is a number of not less than 0.5 and not more than 20,
   and the dispersion medium D, in which:
      the dispersion medium D contains at least one compound selected from the group consisting of a (poly)alkylene glycol, a (poly)alkylene glycol derivative, a terpene alcohol, glycerin and a glycerin derivative;
      the content of the copper nanoparticles A in the dispersion is more than 25% by mass and less than 97% by mass;
      the content of the carboxylic acid B in the dispersion is not less than 0.1% by mass and not more than 7.5% by mass;
      the content of the compound C in the dispersion is not less than 0.05% by mass and not more than 7.5% by mass;
      the total content of the carboxylic acid B and the compound C in the dispersion is not less than 0.85% by mass and not more than 8% by mass; and
      a molecular weight of the dispersion medium D is not less than 60 and not more than 600.
<4> The copper fine particle dispersion according to any one of the above aspects <1> to <3> which contains the copper nanoparticles A, the carboxylic acid B having not less than 6 and not more than 14 carbon atoms, the compound C represented by the formula (1):

   RO-(CH₂CH₂O)ₙ-CH₂-COOH (1)

   wherein R is a hydrocarbon group having not less than 6 and not more than 14 carbon atoms; and n represents an average molar number of addition of ethyleneoxy groups, and is a number of not less than 4 and not more than 12,
   and the dispersion medium D, in which:
      the dispersion medium D contains at least one compound selected from the group consisting of a (poly)alkylene glycol, a (poly)alkylene glycol derivative, a terpene alcohol, glycerin and a glycerin derivative;
      the content of the copper nanoparticles A in the dispersion is not less than 40% by mass and not more than 93% by mass;
      the content of the carboxylic acid B in the dispersion is not less than 0.3% by mass and not more than 6% by mass;
      the content of the compound C in the dispersion is not less than 0.05% by mass and not more than 6% by mass;
      the total content of the carboxylic acid B and the compound C in the dispersion is not less than 0.85% by mass and not more than 7% by mass;
      the boiling point of the dispersion medium D is not lower than 180 °C and not higher than 400 °C; and
      the molecular weight of the dispersion medium D is not less than 60 and not more than 600.
<5> The copper fine particle dispersion according to any one of the above aspects <1> to <4> which contains the copper nanoparticles A, the carboxylic acid B having not less than 6 and not more than 12 carbon atoms, the compound C represented by the formula (1):

   RO-(CH₂CH₂O)ₙ-CH₂-COOH (1)

   wherein R is a hydrocarbon group having not less than 8 and not more than 12 carbon atoms; and n represents an average molar number of addition of ethyleneoxy groups, and is a number of not less than 4 and not more than 12,
   and the dispersion medium D, in which:
      the dispersion medium D contains at least one compound selected from the group consisting of a (poly)alkylene glycol, a (poly)alkylene glycol derivative and a terpene alcohol;
      the content of the copper nanoparticles A in the dispersion is not less than 50% by mass and not more than 91% by mass;
      the content of the carboxylic acid B in the dispersion is not less than 0.3% by mass and not more than 6% by mass;
      the content of the compound C in the dispersion is not less than 0.05% by mass and not more than 6% by mass;
      the total content of the carboxylic acid B and the compound C in the dispersion is not less than 0.85% by mass and not more than 7% by mass;
      the boiling point of the dispersion medium D is not lower than 200 °C and not higher than 400 °C; and
      the molecular weight of the dispersion medium D is not less than 100 and not more than 450.
<6> The copper fine particle dispersion according to any one of the above aspects <1> to <5> which contains the copper nanoparticles A, the carboxylic acid B having not less than 6 and not more than 12 carbon atoms, the compound C represented by the formula (1):

   RO-(CH₂CH₂O)ₙ-CH₂-COOH (1)

   wherein R is a hydrocarbon group having not less than 8 and not more than 12 carbon atoms; and n represents an average molar number of addition of ethyleneoxy groups, and is a number of not less than 6 and not more than 10,
   and the dispersion medium D, in which:
      the dispersion medium D contains at least one compound selected from the group consisting of a (poly)alkylene glycol, a (poly)alkylene glycol derivative and a terpene alcohol;
      the content of the copper nanoparticles A in the dispersion is not less than 50% by mass and not more than 91% by mass;
      the content of the carboxylic acid B in the dispersion is not less than 0.5% by mass and not more than 4% by mass;
      the content of the compound C in the dispersion is not less than 0.5% by mass and not more than 2.5% by mass;
      the total content of the carboxylic acid B and the compound C in the dispersion is not less than 1% by mass and not more than 5% by mass;
      the boiling point of the dispersion medium D is not lower than 220 °C and not higher than 400 °C;
      the molecular weight of the dispersion medium D is not less than 130 and not more than 400; and
      a content of the dispersion medium D in the dispersion is not less than 3% by mass and less than 10% by mass.
<7> The copper fine particle dispersion according to any one of the above aspects <1> to <6>, wherein an average particle size of the copper nanoparticles A is not less than 100 nm and not more than 350 nm.
<8> The copper fine particle dispersion according to any one of the above aspects <1> to <7>, wherein a mass ratio of the content of the compound C to the content of the carboxylic acid B is not less than 0.05 and not more than 9.
<9> The copper fine particle dispersion according to any one of the above aspects <1> to <8>, wherein the dispersion medium D contains at least one compound selected from the group consisting of dipropylene glycol, tetraethylene glycol, a polyethylene glycol having a number-average molecular weight of not less than 180 and not more than 500, □-terpineol and diethylene glycol monobutyl ether.
<10> The copper fine particle dispersion according to any one of the above aspects <1> to <9>, further containing copper microparticles, in which an average particle size of the copper microparticles is more than 0.35 µm and not more than 10 µm.
<11> The copper fine particle dispersion according to the above aspect <10>, wherein a content of the copper microparticles in the dispersion is not less than 5% by mass and not more than 65% by mass.
<12> The copper fine particle dispersion according to any one of the above aspects <1> to <11> which is used for bonding a plurality of metal members to each other.
<13> A method for producing a bonded body, including the steps of allowing the copper fine particle dispersion according to any one of the above aspects <1> to <11> to intervene between the plurality of metal members; and heating the dispersion between the plurality of metal members.
<14> The method for producing a bonded body according to the above aspect <13>, wherein a temperature of a heat treatment in the heating step is not higher than 230 °C.
<15> The method for producing a bonded body according to the above aspect <13> or <14>, wherein an atmosphere used in the heating step is an inert gas atmosphere.
<16> The method for producing a bonded body according to any one of the above aspects <13> to <15>, wherein the metal members include at least one member selected from the group consisting of a gold substrate, a gold-plated substrate, a silver substrate, a silver-plated metal substrate, a copper substrate, a palladium substrate, a palladium-plated metal substrate, a platinum substrate, a platinum-plated metal substrate, an aluminum substrate, a nickel substrate, a nickel-plated metal substrate, a tin substrate, a tin-plated metal substrate, and a metal portion of an electrically insulating substrate.
<17> The method for producing a bonded body according to any one of the above aspects <13> to <16>, wherein the bonding of the metal members is at least one selected from the group consisting of bonding between a chip element and a circuit substrate, bonding between a semiconductor chip and a lead frame or a circuit substrate, and bonding between a high heat generation semiconductor chip and a cooling plate.

### EXAMPLES

The present invention is described in more detail below by referring to the following Examples, etc. However, these Examples, etc., are not intended to limit the scope of the present invention thereto.

In addition, in the following Production Examples, Examples and Comparative Examples, the "part(s)" and "%" indicate "part(s) by mass" and "% by mass", respectively, unless otherwise specified.

The respective various properties were measured or calculated by the following methods.

### [Average Particle Sizes of Copper Nanoparticles A and Copper Microparticles]

The copper nanoparticles A and the copper microparticles were respectively observed and microphotographed by a scanning electron microscope "S-4800" (field emission-type scanning electron microscope) available from Hitachi High-Technologies Corporation to obtain scanning electron microscopic (SEM) images of these particles. The magnification of the respective SEM images was determined according to the particle sizes of the respective particles to microphotograph these particles in the magnification range of from 5000 to 150000 times. The thus obtained SEM images were respectively analyzed by using an image analyzing software "Image J" available from The National Institutes of Health to measure particle sizes of the 100 or more particles per one sample. The arithmetic mean values of the thus measured particle sizes of the copper nanoparticles A and the copper microparticles were defined as respective average particle sizes of the copper nanoparticles A and the copper microparticles.

### [Calculation of Content of Carboxylic Acid B in Dry Powder of Copper Nanoparticles A Containing Carboxylic Acid B]

Using a differential thermogravimetric simultaneous measurement apparatus (TG/DTA) "STA7200RV" (tradename) available from Hitachi High-Tech Science Corporation, 10 mg of a sample to be measured (a dry powder of the copper nanoparticles A containing the carboxylic acid B) was weighed in an aluminum pan cell, heated from 35 °C to 550 °C at a temperature rise rate of 10 °C/min under a nitrogen flow of 50 mL/min to measure a reduced mass of the sample. The reduced mass of the sample as measured in a temperature range of from 35 °C to 550 °C was defined as a mass of the carboxylic acid B, and a mass of the residue at 550 °C was defined as a mass of the copper nanoparticles A to calculate a content of the carboxylic acid B according to the following formula.

Content of carboxylic acid B [% by mass] = 100 x (reduced mass of sample as measured in a temperature range of from 35 °C to 550 °C)/(reduced mass of sample as measured in a temperature range of from 35 °C to 550 °C + mass of residue at 550 °C)

### [Calculation of Content of Carboxylic Acid B in Dry Powder of Copper microparticles A Containing Carboxylic Acid B]

The same procedure as described in the above item "[Calculation of Content of Carboxylic Acid B in Dry Powder of Copper Nanoparticles A Containing Carboxylic Acid B]" was repeated except that the sample was replaced with a dry powder of copper microparticles a containing the carboxylic acid B, thereby calculating a content of the carboxylic acid B in the dry powder of the copper microparticles a.

### (Synthesis of Copper Nanoparticle Dry Powder)

### Synthesis Example 1 (Production of Copper Nanoparticle A1)

A 2 L beaker was charged with 50.0 g of copper oxide "N-120" available from Nissin Chemco Ltd., as a copper raw material compound, 4.40 g of hexanoic acid (guaranteed reagent) available from FUJIFILM Wako Pure Chemical Corporation and 500 g of ethanol (95) (guaranteed reagent) available from FUJIFILM Wako Pure Chemical Corporation, and the contents of the beaker were stirred for 15 minutes. During the stirring, the obtained reaction mixed solution was controlled to a temperature of 70 °C in an oil both.

Next, 63.0 g of hydrazine monohydrate (guaranteed reagent) available from FUJIFILM Wako Pure Chemical Corporation was charged into a 50 mL dropping funnel, and then added dropwise to the aforementioned mixed solution at 25 °C over 20 minutes. Thereafter, the resulting reaction solution was stirred for 1 hour while controlling the temperature of the reaction solution at 70 °C in an oil both, and then air-cooled, thereby obtaining a reddish brown dispersion containing copper nanoparticles.

Using a cooling centrifuge "himac CR22G" and a rotor "R12A" (radius: 15.1 cm) both available from Hitachi Koki Co., Ltd., the whole amount of the thus obtained dispersion was charged into a centrifuge precipitation tube "500PA Bottle" available from Hitachi Koki Co., Ltd., and then subjected to centrifugal separation while applying a centrifugal acceleration of 675 G to the dispersion at a rotating speed of 2000 revolutions/min, followed by maintaining this condition for 30 minutes. Then, 300 g of acetone (first-grade reagent) available from FUJIFILM Wako Pure Chemical Corporation was added to a precipitate separated by the above centrifugal separation, and the resulting mixture was stirred for 5 minutes to redisperse the precipitate in acetone. The whole amount of the thus obtained redispersed solution was subjected again to centrifugal separation under the same conditions as above to thereby separate a precipitate therefrom. The above procedure was repeated twice.

Next, 300 g of methanol (guaranteed reagent) available from FUJIFII,M Wako Pure Chemical Corporation was added to the resulting precipitate, and the resulting mixture was stirred for 15 minutes to redisperse the precipitate in methanol. The whole amount of the thus obtained redispersed solution was subjected again to centrifugal separation under the same conditions as above to thereby separate a precipitate therefrom. The above procedure was repeated twice.

Using a freeze dryer "Model No.: FDU-2110" available from TOKYO RIKAKIKAI CO., LTD., equipped with a dry chamber "Model No.: DRC-1000" available from TOKYO RIKAKIKAI CO., LTD., the resulting purified precipitate of the copper nanoparticles was freeze-dried, thereby obtaining 38.0 g of copper nanoparticles A-1. The freeze-drying conditions used above include operations of freezing at -25 °C for 1 hour, drying under a reduced pressure of 5 Pa at -10 °C for 9 hours, and further drying under a reduced pressure of 5 Pa at 25 °C for 5 hours, thereby obtaining a dry powder of the copper nanoparticles A1 containing the hexanoic acid. The average particle size of the thus obtained copper nanoparticles was 250 nm, and the content of the hexanoic acid in the copper nanoparticles A1 was 0.9% by mass.

### Synthesis Example 2 (Production of Copper Nanoparticles A3)

The same procedure as in Synthesis Example 1 was repeated except that the hexanoic acid was replaced with stearic acid, thereby obtaining a dry powder of copper nanoparticles A3 containing the stearic acid. The average particle size of the thus obtained copper nanoparticles A3 was 240 nm, and the content of the stearic acid in the copper nanoparticles A3 was 1.0% by mass.

### (Synthesis of Copper Microparticles)

### Synthesis Example 3 (Production of Copper Microparticles a1)

The same procedure as in Synthesis Example 1 was repeated except that the amount of the hexanoic acid added was changed from 4.40 g to 0.50 g, thereby obtaining a dry powder of copper microparticles a1 containing the hexanoic acid. The average particle size of the thus obtained copper microparticles a1 was 1.0 µm, and the content of the hexanoic acid in the copper microparticles was 0.3% by mass.

### Synthesis Example 4 (Production of Copper Microparticles a2)

The same procedure as in Synthesis Example 3 was repeated except that the hexanoic acid was replaced with lauric acid, thereby obtaining a dry powder of copper microparticles a2 containing the lauric acid. The average particle size of the thus obtained copper microparticles a2 was 1.1 µm, and the content of the lauric acid in the copper microparticles a2 was 0.3% by mass.

### (Synthesis of Compound C)

### Synthesis Example 5 (Production of Compound C1)

According to ordinary methods (as described in JP 2008-303207A, etc.), a compound C1 (about 10% by mass hydrate) was obtained. Using a freeze dryer "Model No.: FDU-2110" available from TOKYO RIKAKIKAI CO., LTD., equipped with a dry chamber "Model No.: DRC-1000" available from TOKYO RIKAKIKAI CO., LTD., the resulting hydrate of the compound C1 was frozen at -25 °C for 1 hour, then dried under a reduced pressure of 5 Pa at -10 °C for 9 hours, and further dried under a reduced pressure of 5 Pa at 25 °C for 5 hours, thereby obtaining a dry powder of the compound C 1. The compound C1 was a compound represented by the formula (1) in which R is an n-octenyl group, and n is a number of 8.

### Synthesis Example 6 (Production of Compound C2)

A procedure similar to that described in Synthesis Example 5 was conducted to obtain a compound C2. The thus obtained compound C2 was a compound represented by the formula (1) in which R is a lauryl group, and n is a number of 10.

### Synthesis Example 7 (Production of Compound C3)

A procedure similar to that described in Synthesis Example 5 was conducted to obtain a compound C3. The thus obtained compound C3 was a compound represented by the formula (1) in which R is a lauryl group, and n is a number of 6.

### Synthesis Example 8 (Production of Compound C4)

A procedure similar to that described in Synthesis Example 5 was conducted to obtain a compound C4. The thus obtained compound C4 was a compound represented by the formula (1) in which R is an oleyl group, and n is a number of 9.

### Example 1

### (Preparation of Copper Fine Particle Dispersion)

Dipropylene glycol (first-grade reagent) available from FUJIFILM Wako Pure Chemical Corporation, tetraethylene glycol (first-grade reagent) available from FUJIFILM Wako Pure Chemical Corporation, the dry powder of the copper nanoparticles A1 containing the hexanoic acid obtained in Synthesis Example 1, and the compound C1 obtained in Synthesis Example 5 were weighed in amounts of 0.49 g, 0.5 g, 9.0 g and 0.01 g, respectively, and charged into an agate mortar, and then mixed and kneaded together until the dry powder disappeared when visually observed. The resulting mixed solution was transferred into a plastic bottle. The plastic bottle was hermetically sealed, and the contents of the thus sealed plastic bottle were stirred at 2000 min⁻¹ (2000 revolutions/min) for 5 minutes using a planetary rotation type stirring device "Planetary Vacuum Mixer ARV-310" available from Thinky Corporation, thereby obtaining a copper fine particle dispersion 1.

### (Production of Bonded Body)

Using the thus obtained copper fine particle dispersion 1, a bonded body was produced by the following method.

First, a stainless steel metallic mask (thickness: 150 µm) having three 6 mm x 6 mm square openings formed in rows therethrough was placed on a copper plate (whole thickness: 1 mm) having a size of 30 mm x 30 mm. The copper fine particle dispersion was applied onto the copper plate by stencil printing using a metallic squeegee. Thereafter, the copper fine particle dispersion thus applied to the copper plate was dried on a Shamal hot plate "HHP-441" available from AS One Corporation at 120 °C for 10 minutes in the atmospheric air. Then, a silicon chip (thickness: 400 µm) having a size of 5 mm x 5 mm onto which titanium, nickel and gold had been applied in this order by sputter treatment was prepared. The silicon chip was put on the copper fine particle dispersion applied onto the copper plate such that the gold on the silicon chip was brought into contact with the copper fine particle dispersion, thereby obtaining a laminate in which the copper plate, the copper fine particle dispersion and the silicon chip were sequentially laminated on each other in this order.

The resulting laminate was fired by the following method to obtain a bonded body. In the method, the laminate was first disposed in a pressure firing device "HTM-1000" available from Meisyo Kiko Co., Ltd., and nitrogen was flowed through a furnace of the device at a rate of 500 mL/min to replace air in the furnace with the nitrogen. Thereafter, while pressing the laminate between upper and lower heating heads under a pressure of 20 MPa, the temperature of the respective heating heads was raised up to 200 °C over 10 minutes. After being raised to 200 °C, the laminate was maintained between the heating heads at 200 °C for 150 seconds to subject the laminate to sintering treatment, thereby obtaining the bonded body. After the sintering treatment, the heating heads were water-cooled at a rate of -60 °C/min, and then the resulting bonded body was taken out of the device into the atmospheric air at a head temperature of 100 °C or lower.

### Examples 2 to 18 and Comparative Examples 1 to 8

The same procedure as in Example 1 was repeated except that the formulated composition of the copper fine particle dispersion was changed to those shown in Table 1, thereby obtaining the respective copper fine particle dispersions and bonded bodies of Examples 2 to 18 and Comparative Examples 1 to 8.

The raw materials used for production of the copper fine particle dispersions are enumerated below.
Dry powder of copper nanoparticles A2 containing lauric acid "CH200L1" (average particle size: 190 nm; lauric acid content: 1.3% by mass) available from Mitsui Mining & Smelting Co., Ltd.
Hexanoic acid (guaranteed reagent) available from FUJIFILM Wako Pure Chemical Corporation
Lauric acid (first-grade reagent) available from FUJIFILM Wako Pure Chemical Corporation
Stearic acid (guaranteed reagent) available from FUJIFILM Wako Pure Chemical Corporation
Dipropylene glycol (DPG; first-grade reagent) available from FUJIFILM Wako Pure Chemical Corporation
Tetraethylene glycol (TEG; first-grade reagent) available from FUJIFII,M Wako Pure Chemical Corporation
PEG 200 (first-grade reagent; Polyalkylene Glycol 200) available from FUJIFII,M Wako Pure Chemical Corporation
PEG 400 (first-grade reagent; Polyalkylene Glycol 400) available from FUJIFII,M Wako Pure Chemical Corporation
□-Terpineol (guaranteed reagent) available from FUJIFILM Wako Pure Chemical Corporation
Diethylene glycol monobutyl ether (guaranteed reagent) available from FUJIFILM Wako Pure Chemical Corporation

The respective copper fine particle dispersions and bonded bodies obtained in Examples 1 to 18 and Comparative Examples 1 to 8 were subjected to the following evaluation procedures.

### <Evaluation>

### [Bonding Strength of Bonded Body]

The bonding strength of the bonded body was measured according to the following procedure.

Using a universal bond tester "Prospector" available from Nordson Advanced Technology K.K., the silicon chip of the bonded body was pressed in the horizontal direction at a testing speed of 5 mm/min and a shear height of 50 µm to measure a die shear strength of the bonded body. Three samples for each of the obtained bonded bodies were subjected to the above test, and an average value of the thus measured die shear strengths of the three samples of each bonded body was defined as a bonding strength of the bonded body. The results are shown in Table 2.

### [Storage Stability of Copper Fine Particle Dispersion]

The copper fine particle dispersion was stored under the conditions of a temperature of 25 °C and a humidity of 50% for one month. After that, the same method as described above was conducted to measure a bonding strength of the respective bonded bodies. The results are shown in Table 2.

**TABLE 1-1**

| | Dry powder of copper nanoparticles A containing carboxylic acid B | | Dry powder of copper microparticles containing carboxylic acid B | | Carboxylic acid B | | Compound C | | Dispersion medium D | | | |
|---|---|---|---|---|---|---|---|---|---|---|---|---|
| | Kind of copper nanoparticles A | Part(s) by mass | Kind of copper microparticles | Part(s) by mass | Kind | Part(s) by mass | Kind | Part(s) by mass | Kind | Part(s) by mass | Kind | Part(s) by mass |
| Example 1 | A1 | 90 | - | - | - | - | C1 | 0.1 | DPG*¹ | 4.9 | TEG*² | 5.0 |
| Example 2 | A1 | 90 | - | - | - | - | C1 | 1.0 | DPG*¹ | 4.0 | TEG*² | 5.0 |
| Example 3 | A1 | 90 | - | - | - | - | C1 | 2.5 | DPG*¹ | 2.5 | TEG*² | 5.0 |
| Example 4 | A1 | 90 | - | - | - | - | C1 | 5.0 | DPG*¹ | 5.0 | - | - |
| Example 5 | A1 | 90 | - | - | Hexanoic acid | 0.1 | C1 | 1.0 | DPG*¹ | 3.9 | TEG*² | 5.0 |
| Example 6 | A1 | 90 | - | - | Hexanoic acid | 1.0 | C1 | 1.0 | DPG*¹ | 3.0 | TEG*² | 5.0 |
| Example 7 | A1 | 90 | - | - | Hexanoic acid | 2.5 | C1 | 1.0 | DPG*¹ | 1.5 | TEG*² | 5.0 |
| Example 8 | A1 | 90 | - | - | Hexanoic acid | 5.0 | C1 | 1.0 | DPG*¹ | 4.0 | - | - |
| Example 9 | A1 | 90 | - | - | - | - | C2 | 1.0 | DPG*¹ | 4.0 | TEG*² | 5.0 |
| Example 10 | A1 | 90 | - | - | - | - | C3 | 1.0 | DPG*¹ | 4.0 | TEG*² | 5.0 |
| Example 11 | A2 | 90 | - | - | Lauric acid | 1.0 | C1 | 1.0 | DPG*¹ | 3.0 | TEG*² | 5.0 |
| Example 12 | A2 | 90 | - | - | - | - | C1 | 1.0 | DPG*¹ | 4.0 | TEG*² | 5.0 |
| Example 13 | A1 | 60 | a1 | 30 | Hexanoic acid | 1.0 | C1 | 1.0 | DPG*¹ | 3.0 | TEG*² | 5.0 |
| Example 14 | A2 | 60 | a2 | 30 | Lauric acid | 1.0 | C1 | 1.0 | DPG*¹ | 3.0 | TEG*² | 5.0 |
| Example 15 | A1 | 90 | - | - | Hexanoic acid | 1.0 | C1 | 1.0 | DPG*¹ | 3.0 | PEG200 | 5.0 |
| Example 16 | A1 | 90 | - | - | Hexanoic acid | 1.0 | C1 | 1.0 | DPG*¹ | 3.0 | PEG400 | 5.0 |
| Example 17 | A1 | 90 | - | - | Hexanoic acid | 1.0 | C1 | 1.0 | □-Terpineol | 3.0 | TEG*² | 5.0 |
| Example 18 | A1 | 90 | - | - | Hexanoic acid | 1.0 | C1 | 1.0 | Diethylene glycol monobutyl ether | 3.0 | TEG*² | 5.0 |

**TABLE 1-2**

| | Dry powder of copper nanoparticles A containing carboxylic acid B | | Dry powder of copper microparticles containing carboxylic acid B | | Carboxylic acid B | | Compound C | | Dispersion medium D | | | |
|---|---|---|---|---|---|---|---|---|---|---|---|---|
| | Kind of copper nanoparticles A | Part(s) by mass | Kind of copper microparticles | Part(s) by mass | Kind | Part(s) by mass | Kind | Part(s) by mass | Kind | Part(s) by mass | Kind | Part(s) by mass |
| Comparative Example 1 | A1 | 90 | - | - | - | - | - | - | DPG*¹ | 5.0 | TEG*² | 5.0 |
| Comparative Example 2 | A1 | 90 | - | - | - | - | C1 | 8.0 | DPG*¹ | 2.0 | - | - |
| Comparative Example 3 | A1 | 90 | - | - | Hexanoic acid | 1.0 | - | - | DPG*¹ | 4.0 | TEG*² | 5.0 |
| Comparative Example 4 | A1 | 90 | - | - | Hexanoic acid | 7.0 | C1 | 1.0 | DPG*¹ | 2.0 | - | - |
| Comparative Example 5 | A1 | 90 | - | - | - | - | C4 | 1.0 | DPG*¹ | 4.0 | TEG*² | 5.0 |
| Comparative Example 6 | A2 | 90 | - | - | Lauric acid | 1.0 | - | - | DPG*¹ | 4.0 | TEG*² | 5.0 |
| Comparative Example 7 | A2 | 90 | - | - | - | - | - | - | DPG*¹ | 5.0 | TEG*² | 5.0 |
| Comparative Example 8 | A3 | 90 | - | - | Stearic acid | 1.0 | C1 | 1.0 | DPG*¹ | 3.0 | TEG*² | 5.0 |

| | | | | | | | | | | | | |
|---|---|---|---|---|---|---|---|---|---|---|---|---|
| Note DPG*1: Dipropylene glycol; TEG*2: Tetraethylene glycol | | | | | | | | | | | | |

**TABLE 2**

| | Content of copper nanoparticles A (% by mass) | Content of carboxylic acid B (% by mass) | Content of compound C (% by mass) | Total content of carboxylic acid B and compound C (% by mass) | Mass ratio of content of compound C to content of carboxylic acid B (compound C/carboxylic acid B) | Evaluation items | |
|---|---|---|---|---|---|---|---|
| | | | | | | Die shear strength (MPa) | Storage stability (MPa) |
| Example 1 | 89.2 | 0.81 | 0.1 | 0.91 | 0.1 | 19 | 15 |
| Example 2 | 89.2 | 0.81 | 1.0 | 1.81 | 1.2 | 24 | 20 |
| Example 3 | 89.2 | 0.81 | 2.5 | 3.31 | 3.1 | 21 | 17 |
| Example 4 | 89.2 | 0.81 | 5.0 | 5.81 | 6.2 | 18 | 15 |
| Example 5 | 89.2 | 0.91 | 1.0 | 1.91 | 1.1 | 24 | 21 |
| Example 6 | 89.2 | 1.81 | 1.0 | 2.81 | 0.6 | 24 | 23 |
| Example 7 | 89.2 | 3.31 | 1.0 | 4.31 | 0.3 | 22 | 21 |
| Example 8 | 89.2 | 5.81 | 1.0 | 6.81 | 0.2 | 16 | 15 |
| Example 9 | 89.2 | 0.81 | 1.0 | 1.81 | 1.2 | 22 | 19 |
| Example 10 | 89.2 | 0.81 | 1.0 | 1.81 | 1.2 | 22 | 19 |
| Example 11 | 88.8 | 2.17 | 1.0 | 3.17 | 0.5 | 22 | 21 |
| Example 12 | 88.8 | 1.17 | 1.0 | 2.17 | 0.9 | 22 | 19 |
| Example 13 | 59.5 | 1.63 | 1.0 | 2.63 | 0.6 | 30 | 29 |
| Example 14 | 59.2 | 1.87 | 1.0 | 2.87 | 0.5 | 27 | 26 |
| Example 15 | 89.2 | 1.81 | 1.0 | 2.81 | 0.6 | 24 | 23 |
| Example 16 | 89.2 | 1.81 | 1.0 | 2.81 | 0.6 | 22 | 21 |
| Example 17 | 89.2 | 1.81 | 1.0 | 2.81 | 0.6 | 23 | 22 |
| Example 18 | 89.2 | 1.81 | 1.0 | 2.81 | 0.6 | 23 | 22 |
| Com. Ex. 1 | 89.2 | 0.81 | 0.0 | 0.81 | 0 | Undispersible | Undispersible |
| Com. Ex. 2 | 89.2 | 0.81 | 8.0 | 8.81 | 0 | Undispersible | Undispersible |
| Com. Ex. 3 | 89.2 | 1.81 | 0.0 | 1.81 | 0 | Undispersible | Undispersible |
| Com. Ex. 4 | 89.2 | 7.81 | 1.0 | 8.81 | 0.1 | Undispersible | Undispersible |
| Com. Ex. 5 | 89.2 | 0.81 | 1.0 | 1.81 | 1.2 | Undispersible | Undispersible |
| Com. Ex. 6 | 88.8 | 2.17 | 0.0 | 2.17 | 0 | Undispersible | Undispersible |
| Com. Ex. 7 | 88.8 | 1.17 | 0.0 | 1.17 | 0 | Undispersible | Undispersible |
| Com. Ex. 8 | 89.1 | 1.90 | 1.0 | 2.90 | 0.5 | Undispersible | Undispersible |

As recognized from Table 2, the copper fine particle dispersions obtained in Examples 1 to 18 were capable of improving bonding strength of the bonded bodies obtained therefrom even when being subjected to pressure firing at 200 °C in a nitrogen atmosphere, and were also capable of providing the bonded bodies having good bonding strength even after storing the copper fine particle dispersions for one month. Whereas, the copper fine particle dispersions obtained in Comparative Examples 1 to 8 were found to be undispersible. From the above results, it was confirmed that the copper fine particle dispersions of the present invention were capable of improving bonding strength of the resulting bonded bodies even when being subjected to firing at 200 °C in a nitrogen atmosphere, and also had good storage stability.

## Claims

1. A copper fine particle dispersion comprising copper nanoparticles A, a carboxylic acid B having not less than 6 and not more than 14 carbon atoms, a compound C represented by the formula (1):
RO-(CH₂CH₂O)ₙ-CH₂-COOH (1)
wherein R is a hydrocarbon group having not less than 6 and not more than 14 carbon atoms; and n represents an average molar number of addition of ethyleneoxy groups, and is a number of not less than 0.5 and not more than 20,
and a dispersion medium D, in which:
the dispersion medium D comprises at least one compound selected from the group consisting of a (poly)alkylene glycol, a (poly)alkylene glycol derivative, a terpene alcohol, glycerin and a glycerin derivative;
a content of the carboxylic acid B in the dispersion is not less than 0.1% by mass;
a content of the compound C in the dispersion is not less than 0.05% by mass; and
a total content of the carboxylic acid B and the compound C in the dispersion is not more than 8% by mass.

2. The copper fine particle dispersion according to claim 1, wherein a content of the copper nanoparticles A in the dispersion is more than 25% by mass and less than 97% by mass.

3. The copper fine particle dispersion according to claim 1 or 2, wherein the content of the carboxylic acid B in the dispersion is not more than 7.5% by mass.

4. The copper fine particle dispersion according to any one of claims 1 to 3, wherein the content of the compound C in the dispersion is not more than 7.5% by mass.

5. The copper fine particle dispersion according to any one of claims 1 to 4, wherein the total content of the carboxylic acid B and the compound C in the dispersion is not less than 0.85% by mass.

6. The copper fine particle dispersion according to any one of claims 1 to 5, wherein the compound C comprises a compound represented by the formula (1) in which R is a linear saturated alkyl group having not less than 6 and not more than 14 carbon atoms, and n is a number of not less than 4 and not more than 12.

7. The copper fine particle dispersion according to any one of claims 1 to 6, wherein a mass ratio of the content of the compound C to the content of the carboxylic acid B is not less than 0.05 and not more than 9.

8. The copper fine particle dispersion according to any one of claims 1 to 7, wherein a content of the dispersion medium D in the dispersion is not less than 3% by mass and less than 10% by mass.

9. The copper fine particle dispersion according to any one of claims 1 to 8, wherein a boiling point of the dispersion medium D is not lower than 180 °C, and a molecular weight of the dispersion medium D is not more than 600.

10. The copper fine particle dispersion according to any one of claims 1 to 9, further comprising copper microparticles.

11. The copper fine particle dispersion according to claim 10, wherein a content of the copper microparticles in the dispersion is not less than 5% by mass and not more than 65% by mass.

12. The copper fine particle dispersion according to claim 10 or 11, wherein an average particle size of the copper microparticles is more than 0.35 µm and not more than 10 µm.

13. The copper fine particle dispersion according to any one of claims 1 to 12, which is used for bonding a plurality of metal members to each other.

14. A method for producing a bonded body, comprising the steps of allowing the copper fine particle dispersion according to any one of claims 1 to 13 to intervene between the plurality of metal members; and heating the dispersion between the plurality of metal members.

15. The method for producing a bonded body according to claim 14, wherein a temperature of a heat treatment in the heating step is not higher than 230 °C.

16. The method for producing a bonded body according to claim 14 or 15, wherein an atmosphere used in the heating step is an inert gas atmosphere.

17. The method for producing a bonded body according to any one of claims 14 to 16, wherein the metal members comprise at least one member selected from the group consisting of a gold substrate, a gold-plated substrate, a silver substrate, a silver-plated metal substrate, a copper substrate, a palladium substrate, a palladium-plated metal substrate, a platinum substrate, a platinum-plated metal substrate, an aluminum substrate, a nickel substrate, a nickel-plated metal substrate, a tin substrate, a tin-plated metal substrate, and a metal portion of an electrically insulating substrate.

18. The method for producing a bonded body according to any one of claims 14 to 17, wherein the bonding of the metal members is at least one selected from the group consisting of bonding between a chip element and a circuit substrate, bonding between a semiconductor chip and a lead frame or a circuit substrate, and bonding between a high-heat generation semiconductor chip and a cooling plate.
